# EUROPEAN PATENT APPLICATION

(11) **EP 2 184 787 A1**
(43) Date of publication of application: **12.05.2010**
(21) Application number: 08791614.4
(22) Date of filing: 25.07.2008
(51) Int. Cl.: H01L 31/068, H01L 31/0224

(54) **REAR SURFACE BONDING TYPE SOLAR CELL, REAR SURFACE BONDING TYPE SOLAR CELL HAVING WIRING BOARD, SOLAR CELL STRING AND SOAR CELL MODULE**

(30) Priority: 23.08.2007 JP 2007216969
(71) Applicant: Sharp Kabushiki Kaisha, Osaka-shi, Osaka 545-8522 (JP)
(72) Inventor: ISAKA, Takayuki, OSAKA 545-8522 (JP)
(74) Representative: Müller - Hoffmann & Partner
(86) International application number: PCT/JP2008/063370
(87) International publication number: WO 2009/025147

(57) **Abstract**

A back surface contact type solar cell having a first conductivity type region (111) and second conductivity type region (112) formed alternately at one surface of a semiconductor substrate (101), includes an electrode for first conductivity type (121) arranged on the first conductivity type region (111), and an electrode for second conductivity type (122) arranged on the second conductivity type region (112). The back surface contact type solar cell includes a first non-connection region (141) between electrodes for second conductivity type (122) adjacent in an aligning direction of the first conductivity type region (111) and the second conductivity type region (112), impeding electrical connection with the electrode for first conductivity type (121), and a second non-connection region (142) between electrodes for first conductivity type (121) adjacent in the aligning direction, impeding electrical connection with the electrode for second conductivity type (122). A back surface contact type solar cell with a wiring board, a solar cell string, and a solar cell module are also provided.

## Description

### TECHNICAL FIELD

The present invention relates to a back surface contact type solar cell, a back surface contact type solar cell with a wiring board, a solar cell string, and a solar cell module. Particularly, the present invention relates to a back surface contact type solar cell, a back surface contact type solar cell with a wiring board, a solar cell string, and solar cell module that can have the characteristics improved, and that can be connected relatively readily.

### BACKGROUND ART

In recent years, there is a need for the development of clean energy in connection with global environmental issues such as depletion of energy sources and increase of CO₂ in the atmosphere. Particularly, photovoltaic power generation based on solar cells is now in practical use and further development is in progress as a new source of energy.

A conventional solar cell is generally configured based on the formation of a pn junction in the proximity of the surface at the side to which sunlight is incident (light receiving face) by diffusing impurities of a conductivity type opposite to that of the semiconductor substrate towards the light receiving face, and the arrangement of one and the other electrodes at the light receiving face and at the surface opposite to the light receiving face (back face), respectively. It is also common to improve the high power through the back surface field effect by diffusing impurities of a conductivity type identical to that of the semiconductor substrate in high concentration at the back surface.

In a solar cell of the above-described configuration, the electrode arranged at the light receiving surface will block the incident sunlight to suppress the output of the solar cell. In order to overcome this problem, the development of the so-called back surface contact type solar cell having the electrode for first conductivity type and the electrode for second conductivity type (electrode for p type and electrode for n type) both located at the back surface of the semiconductor substrate is now in progress.

Since power can be output from only the back surface side of the semiconductor substrate where the electrode for first conductivity type and the electrode for second conductivity type are arranged in the aforementioned back surface contact type solar cell, the configuration of the electrode for first conductivity type and electrode for second conductivity type is extremely critical from the standpoint of output from the back surface contact type solar cell.

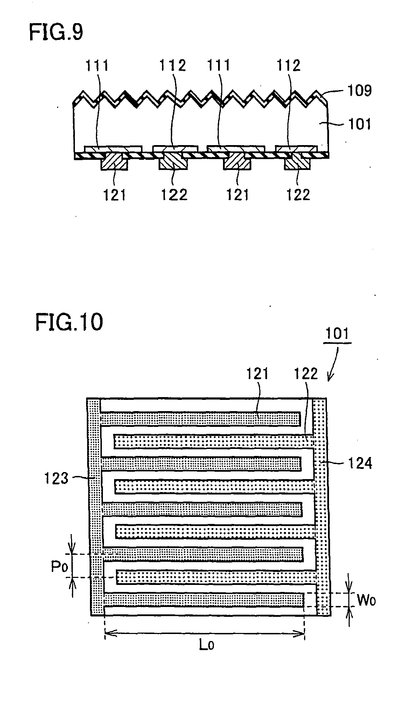

Fig. 9 represents a schematic sectional view of an example of a conventional back surface contact type solar cell. This conventional back surface contact type solar cell has an anti-reflection film 109 formed at the light receiving face of, for example, a p type silicon substrate 101. A p type region 111 and an n type region 112 are formed alternately with a predetermined distance therebetween along the back surface of silicon substrate 101. A finger p electrode 121 is formed on p type region 111. A finger n electrode 122 is formed on n type region 112.

When sunlight is incident on the light receiving face of the back surface contact type solar cell, the carriers generated in the proximity of the light receiving face of silicon substrate 101 arrive at the pn junction formed at the back side of the back surface contact type solar cell to be collected by finger p electrode 121 and finger n electrode 122 to be output.

Fig. 10 represents a schematic plan view of an example of the electrode configuration at the back side of a conventional back surface contact type solar cell. In this conventional back surface contact type solar cell, finger p electrode 121 and finger n electrode 122 are formed at the back side of silicon substrate 101 to cover the entire back surface from the standpoint of improving the output of the back surface contact type solar cell. A bus bar p electrode 123 crossing finger p electrode 121 and a bus bar n electrode 124 crossing finger n electrode 122 are formed at respective ends of silicon substrate 101 at the back surface.

Since output will be lost when the series resistance becomes higher, finger p electrode 121 and finger n electrode 122 are designed such that the cross sectional area (width × height of electrode) is increased from the standpoint of reducing the series resistance.

However, a larger area of the back surface at the back surface contact type solar cell will necessitate a longer length L₀ for finger p electrode 121 and finger n electrode 122 while the electrode width W₀ must be increased to achieve a larger cross sectional area in view of the limit in the height of the electrodes. In the case where width W₀ of the electrode is increased, the pitch Po between finger p electrode 121 and finger n electrode 122 becomes larger to cause a longer moving distance for the carriers in silicon substrate 101, leading to the problem of reduction in the output of the back surface contact type solar cell.

In order to overcome these problems, Japanese Patent Laying-Open No. 2005-260157 (Patent Document 1), for example, discloses a back surface contact type solar cell having at least one of the bus bar electrodes that crosses the finger electrode to be located in the back face of the back surface contact type solar cell.

Further, Japanese Patent Laying-Open No. 2005-340362 (Patent Document 2), for example, discloses a solar cell including a plurality of electrodes for p type and electrodes for n type disposed in a scattered manner at the back face of the back surface contact type solar cell, connected with a wiring board having p type lines and n type lines formed electrically insulated from each other.
Patent Document 1: Japanese Patent Laying-Open No. 2005-260157
Patent Document 2: Japanese Patent Laying-Open No. 2005-340362

### DISCLOSURE OF THE INVENTION

### PROBLEMS TO BE SOLVED BY THE INVENTION

However, the back surface contact type solar cell of Patent Document 1 is configured such that a pn junction cannot be formed at the bus bar electrode region located at the back side of the back surface contact type solar cell. This configuration has become a bottleneck in the design to further improve the characteristics of the back surface contact type solar cell.

The solar cell of Patent Document 2 is disadvantageous in that the electrodes for p type and the electrodes for n type located at the back side of the back surface contact type solar cell cannot be connected with favorable accuracy by the wiring board.

In view of the foregoing, an object of the present invention is to provide a back surface contact type solar cell, a back surface contact type solar cell with a wiring board, a solar cell string, and a solar cell module that can have the characteristics improved, and that can be connected relatively readily.

### MEANS FOR SOLVING THE PROBLEMS

The present invention is directed to a back surface contact type solar cell having a first conductivity type region and a second conductivity type region formed alternately at one surface of a semiconductor substrate. The back surface contact type solar cell includes an electrode for first conductivity type arranged on the first conductivity region, an electrode for second conductivity type arranged on the second conductivity type region, a first non-connection region between the electrodes for second conductivity type adjacent in the aligning direction of the first and second conductivity type regions, and a second non-connection region between electrodes for first conductivity type adjacent in the aligning direction of the first and second conductivity type regions. The first non-connection region serves to impede electrical connection with the electrode for first conductivity type. The second non-connection region serves to impede electrical connection with the electrode for second conductivity type.

In the back surface contact type solar cell of the present invention, the first non-connection region may be at least one of the region where the electrode for first conductivity type is not arranged on the first conductivity type region, and a region where an insulation layer is formed on the surface of the electrode for first conductivity type.

Further, in the back surface contact type solar cell of the present invention, the second non-connection region may be at least one of a region where the electrode for second conductivity type is not arranged on the second conductivity type region and a region where an insulation layer is formed on the surface of the electrode for second conductivity type.

In the back surface contact type solar cell of the present invention, the first non-connection region and the electrode for second conductivity type may be adjacent to each other in the aligning direction of the first and second conductivity type regions.

In the back surface contact type solar cell of the present invention, the second non-connection region and the electrode for first conductivity type may be adjacent to each other in the aligning direction of the first and second conductivity type regions.

Preferably in the back surface contact type solar cell of the present invention, when the semiconductor substrate is rotated 180° with an axis orthogonal to the surface of the semiconductor substrate as an axis of rotation, the shape of the electrode for first conductivity type and the shape of the electrode for second conductivity type are identical or symmetric before and after rotation.

Preferably in the back surface contact type solar cell of the present invention, the area of the second conductivity type region is larger than the area of the first conductivity type region when the semiconductor substrate is of the first conductivity type, and the area of the first conductivity type region is larger than the area of the second conductivity type region when the semiconductor substrate is of the second conductivity type.

In the back surface contact type solar cell of the present invention, the electrode for first conductivity type may take the shape of a strip extending in a direction orthogonal to the aligning direction of the first and second conductivity type regions.

In the back surface contact type solar cell of the present invention, the electrode for second conductivity type may take the shape of a strip extending in a direction orthogonal to the aligning direction of the first and second conductivity type regions

The back surface contact type solar cell of the present invention may include at least one of a first interconnector electrically connecting electrodes for first conductivity type with each other, and a second interconnector electrically connecting electrodes for second conductivity type with each other.

Preferably in the back surface contact type solar cell of the present invention, the electrode for first conductivity type takes the shape of a strip extending in a direction orthogonal to the aligning direction of the first and second conductivity type regions, and the first interconnector is connected in a direction orthogonal to the longitudinal direction of the electrode for first conductivity type.

Preferably in the back surface contact type solar cell of the present invention, the electrode for second conductivity type takes the shape of a strip extending in a direction orthogonal to the aligning direction of the first and second conductivity type regions, and the second interconnector is connected in a direction orthogonal to the longitudinal direction of the electrode for second conductivity type.

In the back surface contact type solar cell of the present invention, the semiconductor substrate may be of an n type, wherein the first conductivity type corresponds to the n type and the second conductivity type corresponds to a p type.

The present invention is also directed to a solar cell string including any of the back surface contact type solar cell set forth above.

The present invention is further directed to a back surface contact type solar cell with a wiring board. The back surface contact type solar cell with a wiring board includes a back surface contact type solar cell set forth above, and a wiring board having an insulative substrate and a conductive wiring member formed on the surface of the insulative substrate. The back surface contact type solar cell is arranged on the wiring member of the wiring board. The back surface contact type solar cell includes a plurality of electrodes for first conductivity type and a plurality of electrodes for second conductivity type. In the back surface contact type solar cell, electrodes for first conductivity type are electrically connected with each other by a wiring member of the wiring board, and electrodes for second conductivity type are electrically connected with each other by a wiring member differing from the wiring member electrically connecting the electrodes for first conductivity type with each other.

The present invention is also directed to a solar cell string based on a plurality of back surface contact type solar cells set forth above, and a wiring board including an insulative substrate and a conductive wiring member formed on the surface of the insulative substrate. Each of the plurality of back surface contact type solar cells is arranged on the wiring member of the wiring board. Each of the back surface contact type solar cells includes a plurality of electrodes for first conductivity type and a plurality of electrodes for second conductivity type. In each of the plurality of back surface contact type solar cells, electrodes for first conductivity type are electrically connected with each other by the wiring member of the wiring board, and electrodes for second conductivity type are electrically connected with each other by a wiring member differing from the wiring member electrically connecting the electrodes for first conductivity type with each other. The wiring member electrically connecting the electrodes for first conductivity type with each other is also a wiring member electrically connecting electrodes for second conductivity type with each other in another adjacent back surface contact type solar cell. The wiring member electrically connecting the electrodes for second conductivity type with each other is also a wiring member electrically connecting electrodes for first conductivity type with each other in another adjacent back surface contact type solar cell.

The present invention is further directed to a solar cell module having the solar cell string set forth above sealed with resin.

### EFFECTS OF THE INVENTION

According to the present invention, there can be provided a back surface contact type solar cell, a back surface contact type solar cell with a wiring board, a solar cell string, and a solar cell module that can have the characteristics improved, and that can be connected relatively readily.

### BRIEF DESCRIPTION OF THE DRAWINGS

Fig. 1 represents a schematic plan view of a back surface of an example of a back surface contact type solar cell of the present invention.
Fig. 2 represents a schematic sectional view to illustrate an example of a method of fabricating the back surface contact type solar cell of Fig. 1.
Fig. 3 represents a schematic plan view of a back surface of an example of a back surface contact type solar cell of the present invention.
Fig. 4 represents a schematic plan view of a back surface of an example of a solar cell string of the present invention.
Fig. 5 represents a schematic plan view of a back surface of an example of a back surface contact type solar cell of the present invention.
Fig. 6 represents a schematic plan view of a back surface of an example of an n type silicon substrate of the present invention.
Fig. 7 represents a schematic plan view of a back surface of an example of a back surface contact type solar cell of the present invention.
Fig. 8 represents a schematic plan view of a back surface of an example of a solar cell string of the present invention.
Fig. 9 represents a schematic sectional view of an example of a conventional back surface contact type solar cell.
Fig. 10 represents a schematic plan view of an example of an electrode configuration at a back surface of a conventional back surface contact type solar cell.
Fig. 11 represents a schematic plan view of an example of a wiring board employed in the present invention.
Fig. 12 represents a schematic plan view of a light receiving face according to an example of a back surface contact type solar cell with a wiring board of the present invention.
Fig. 13 represents a schematic plan view of a back surface of the back surface contact type solar cell with a wiring board of Fig. 12.
Fig. 14 represents a schematic plan view of another example of a wiring board employed in the present invention.
Fig. 15 represents a schematic plan view of a light receiving face according to another example of a solar cell string of the present invention.
Fig. 16 represents a schematic plan view of a back surface of the solar cell string of Fig. 15.
Fig. 17 represents a schematic plan view of a back surface according to an example of a back surface contact type solar cell with a wiring board of the present invention.
Fig. 18 represents a schematic plan view of a back surface according to another example of a solar cell string of the present invention.

### DESCRIPTION OF THE REFERENCE CHARACTERS

100, 100a, 100b, 100c, 100d, 100e, 100f back surface contact type solar cell, 101 n type silicon substrate, 102 passivation film, 102a silicon oxide film, 103a first diffusion mask, 103b second diffusion mask, 104 texture mask, 105, 106 window, 107, 108 contact hole, 109 anti-reflection film, 110 texture structure, 111 p type region, 112 n type region, 121 finger p electrode, 122 finger n electrode, 123 bus bar p electrode, 124 bus bar n electrode, 131 1 first interconnector, 132 second interconnector, 141 first non-connection region, 142 second non-connection region, 150 wiring board, 151 insulative substrate, 152 wiring member, 200, 201 arrow.

### BEST MODES FOR CARRYING OUT THE INVENTION

Embodiments of the present invention will be described hereinafter based on an example in which the first conductivity type is the p type. In the drawings of the present invention, the same reference characters represent the same or corresponding elements.

### <First Embodiment>

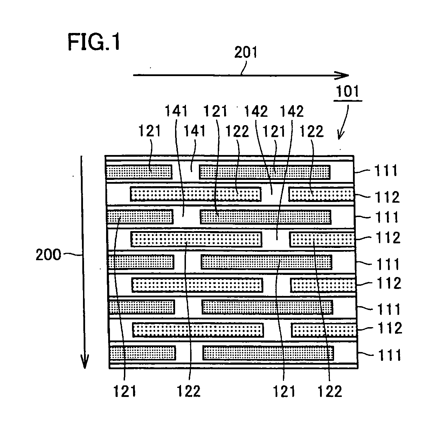

Fig. 1 represents a schematic plan view of a back surface according to an example of a back surface contact type solar cell of the present invention. The back surface contact type solar cell of the present invention has a p type first conductivity type region that is a strip-like region having p type impurities introduced (hereinafter, referred to as "p type region") 111 at the back surface of an n type silicon substrate 101, and an n type second conductivity type region that is a strip-like region having n type impurities introduced (hereinafter, referred to as "n type region") 112 at the back surface of silicon substrate 101, aligned alternately along the direction of arrow 200 shown in Fig. 1.

An electrode for first conductivity type that is the p type (hereinafter, referred to as "finger p electrode") 121 extending as a strip in a direction (direction of arrow 201) orthogonal to the direction of arrow 200 (the aligning direction of p type region 111 and n type region 112) shown in Fig. 1 is formed on p type region 111. An electrode for second conductivity type that is the n type (hereinafter, referred to as "finger n electrode") 122 extending as a strip in a direction (direction of arrow 201) orthogonal to the direction of arrow 200 shown in Fig. 1 (the aligning direction of p type region 111 and n type region 112) is formed on n type region 112.

Finger p electrodes 121 are formed intermittently. The region between finger p electrodes 121 adjacent in the direction of arrow 201 shown in Fig. 1 is identified as a first non-connection region 141 where finger p electrode 121 is not formed.

Finger n electrodes 122 are also formed intermittently. The region between finger n electrodes 122 adjacent in the direction of arrow 201 shown in Fig. 1 is identified as a second non-connection region 142 where finger n electrode 122 is not formed.

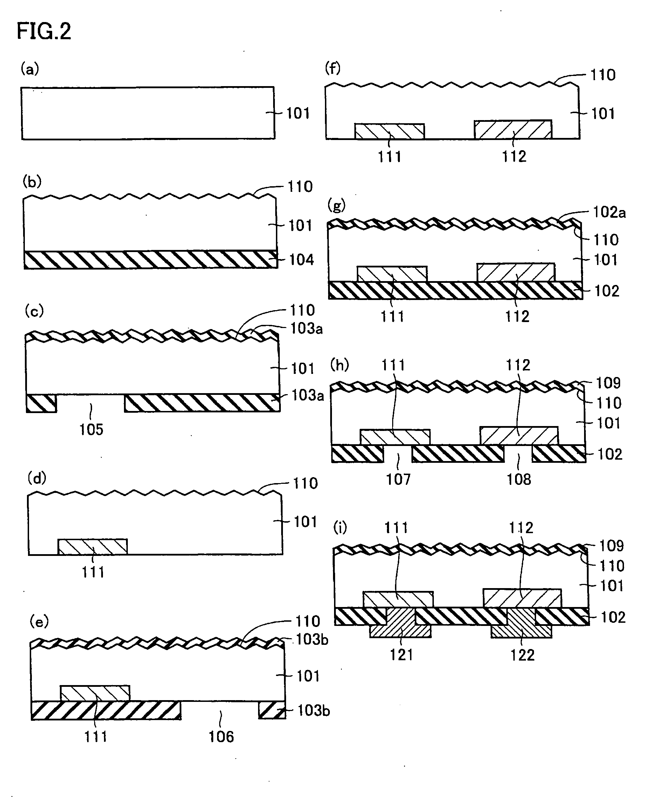

An example of a method of fabricating the back surface contact type solar cell of Fig. 1 will be described hereinafter with reference to the schematic sectional views of (a)-(i) in Fig. 2. For the sake of convenience, (a)-(i) in Fig. 2 correspond to the representation of one p type region 111 and one n type region 112 formed at the back surface of silicon substrate 101.

As shown in Fig. 2 (a), an n type silicon substrate 101 is prepared. For example, a polycrystalline silicon or monocrystalline silicon may be used for silicon substrate 101. The size and configuration of silicon substrate 101 are, but not exclusively, greater than or equal to 100 µm and less than or equal to 3 00 µm in thickness, taking a rectangular shape with one side greater than or equal to 100 mm and less than or equal to 200 mm, for example.

Silicon substrate 101 is preferably removed of a slice damage caused by slicing. Removing a slice damage of silicon substrate 101 can be performed by etching the surface of silicon substrate 101 with a mixed acid of hydrofluoric solution and nitric acid, or an alkaline solution such as sodium hydroxide or the like.

As shown in Fig. 2(b), a texture mask 104 constituted of a silicon oxide film, for example, is deposited at the back surface of silicon substrate 101. A texture structure 110 is formed at the light receiving face of n type silicon substrate 101. Texture structure 110 can be formed by etching the light receiving face of silicon substrate 101 using a solution having isopropyl alcohol added to an alkaline solution such as sodium hydroxide or potassium hydroxide, heated to 70°C or higher and less than or equal to 80°C, for example.

Since only the light receiving face of silicon substrate 101 can be formed with texture structure 110 by depositing a texture mask 104 at the back surface of silicon substrate 101, that back surface can be set flat. Texture mask 104 can be deposited by steam oxidation, atmospheric pressure CVD (Chemical Vapor Deposition) or printing, and baking of spin-on glass and the like. The thickness of texture mask 104 is, but not particularly limited to, greater than or equal to 300 nm and less than or equal to 800 nm.

For texture mask 104, a silicon nitride film or a stacked layer of a silicon oxide film and silicon nitride film may be employed, other than a silicon oxide film. Texture mask 104 constituted of a silicon nitride film can be formed by plasma CVD or atmospheric pressure CVD, for example. The thickness can be set to, but not particularly limited to, greater than or equal to 60 nm and less than or equal to 100 nm.

Texture mask 104 is removed after formation of texture structure 110. Alternatively, texture mask 104 can be employed as a first diffusion mask that will be described afterwards, instead of being removed.

As shown in Fig. 2(c), a first diffusion mask 103a constituted of a silicon oxide film, for example, is formed all over the light receiving face and back surface of silicon substrate 101, and then a region of first diffusion mask 103a corresponding to the formation region of p type region 111 is removed to form a window 105. Thus a portion of the back surface of n type silicon substrate 101 is exposed at window 105.

First diffusion mask 103a constituted of a silicon oxide film can be deposited by steam oxidation, atmospheric pressure CVD, or printing, and baking of spin-on glass and the like. Though not particularly limited, the thickness of first diffusion mask 103a constituted of a silicon oxide film can be set to greater than or equal to 100 nm, and less than or equal to 300 nm, for example. For first diffusion mask 103a, a silicon nitride film or a stacked layer of a silicon oxide film and silicon nitride film may be employed, other than a silicon oxide film. First diffusion mask 103a constituted of a silicon nitride film can be deposited by, for example, plasma CVD or atmospheric pressure CVD, and the thickness can be set to, but not particularly limited to, greater than or equal to 60 nm and less than or equal to 100 nm, for example.

The formation of window 105 by removal of first diffusion mask 103 a at the back surface of silicon substrate 101 can be achieved as set forth below. For example, first etching paste is screen-printed or the like in a desired pattern at the region where first diffusion mask 103a is to be removed at the back surface of silicon substrate 101. Then, n type silicon substrate 101 is heated at 100°C to 400°C, for example, to remove the region of first diffusion mask 103a where the first etching paste has been printed at the back surface of silicon substrate 101. The first etching paste includes, for example, phosphoric acid or ammonium hydrogen fluoride as the etching component, as well as water, an organic solvent, and a thickener as components other than the etching component, and has the viscosity adjusted to suit the printing method such as screenprinting. The method of heating the first etching paste is not particularly limited, and a hot plate, a belt furnace, an oven, or the like may be used for heating.

Following the heating process of the first etching paste set forth above, silicon substrate 101 is immersed in water to be subjected to ultrasonic cleaning by the application of ultrasonic waves, whereby the first etching paste subjected to heating is removed. Thus, window 105 is formed through which a portion of the back surface of silicon substrate 101 is exposed. In addition to ultrasonic cleaning, the back surface of silicon substrate 101 can be subjected to the common SC-1 cleaning (RCA Standard Clean-1), SC-2 cleaning (RCA Standard Clean-2), rinsing with a mixture of sulfuric acid and hydrogen peroxide solution, or rinsing using a rinsing fluid including a weak hydrofluoric solution, weak alkaline solution or a surfactant.

As shown in Fig. 2(d), p type impurities such as boron is vapor phase-diffused to the back surface exposed at window 105 of silicon substrate 101 to form p type region 111 at the back surface of silicon substrate 101. Then, first diffusion mask 103 a and the BSG (Boron Silicate Glass) formed by the diffusion of boron are completely removed using a hydrofluoric solution or the like. P type region 111 may be formed by heating subsequent to applying a solvent including p type impurities such as boron to the back surface of silicon substrate 101 exposed at window 105.

Referring to Fig. 2(e), following formation of a second diffusion mask 103b constituted of a silicon oxide film, for example, completely over the light receiving face and back surface of silicon substrate 101, the region of second diffusion mask 103b corresponding to the formation region of n type region 112 is removed to form window 106. Thus, a portion of the back surface of silicon substrate 101 is exposed at window 106.

The formation of window 106 by removal of second diffusion mask 103b at the back surface of silicon substrate 101 can be achieved as set forth below. For example, second etching paste is screen-printed or the like in a desired pattern at the region where second diffusion mask 103b is to be removed at the back surface of silicon substrate 101. Then, silicon substrate 101 is heated at 100°C to 400°C, for example, to remove the region of second diffusion mask 103b where the second etching paste has been printed at the back surface of silicon substrate 101. For the second etching paste, components similar to those of the first etching paste set forth above may be employed. Alternatively, different components may be employed. The description of first diffusion mask 103a set forth previously similarly applies to second diffusion mask 103b, and the description for the first etching paste set forth previously similarly applies to the second etching paste.

Following the heating process of the second etching paste set forth above, the second etching paste subjected to heating is removed in a manner similar to that of the first etching paste set forth above. Accordingly, window 106 is formed through which a portion of the back surface of silicon substrate 101 is exposed.

As shown in Fig. 2(f), n type region 112 is formed at the back surface of silicon substrate 101 by vapor phase-diffusion of n type impurities such as phosphorus to the exposed surface of silicon substrate 101 through window 106. Then, second diffusion mask 103b and PSG (Phosphorus Silicate Glass) formed by diffusion of phosphorus are completely removed using a hydrofluoric solution or the like. N type region 112 may be formed by heating, subsequent to applying a solvent including n type impurities such as phosphorus to the back surface of silicon substrate 101 exposed at window 106.

Referring to Fig. 2(g), silicon substrate 101 is subjected to dry oxidation (heat oxidation) to form a passivation film 102 constituted of a silicon oxide film all over the back surface of silicon substrate 101. Simultaneous to the formation of passivation film 102, a silicon oxide film 102a is formed all over the light receiving face of silicon substrate 101. Passivation film 102 constituted of a silicon oxide film and silicon oxide film 102a can be produced by, other than dry oxidation, steam oxidation or atmospheric pressure CVD. Further, passivation film 102 may be a silicon nitride film formed by plasma CVD, or a stacked layer of a silicon oxide film and silicon nitride film.

As shown in Fig. 2(h), following complete removal of silicon oxide film 102a from the light receiving face of silicon substrate 101 using a hydrofluoric solution or the like, an anti-reflection film 109 constituted of a silicon nitride film having a refractive index of 1.9 to 2.1, for example, is provided on the light receiving face of silicon substrate 101. Furthermore, passivation film 102 is partially removed to form a contact hole 107 and a contact hole 108 to expose partially the surfaces of p type region 111 and n type region 112.

Contact hole 107 is formed to correspond to the shape of finger p electrode 121. Contact hole 108 is formed to correspond to the shape of finger n electrode 122.

Contact holes 107 and 108 can be formed as set forth below. First, etching paste is printed on passivation film 102, corresponding to the shape of contact hole 107 and contact hole 108. Then, silicon substrate 101 is heated at, for example, 100°C to 400°C, followed by immersion in water to be subjected to ultrasonic cleaning by application of ultrasonic waves. Accordingly, the etching paste subjected to heating is removed. In addition to ultrasonic cleaning, the back surface of silicon substrate 101 can be subjected to the common SC-1 cleaning, SC-2 cleaning, rinsing with a mixture of sulfuric acid and hydrogen peroxide solution, or rinsing using a rinsing fluid including a weak hydrofluoric solution, weak alkaline solution or a surfactant.

Finally, referring to Fig. 2(i), finger p electrode 121 and finger n electrode 122 are formed at respective surfaces of p type region 111 and n type region 112 exposed at contact hole 107 and contact hole 108, respectively. Finger p electrode 121 and finger n electrode 122 can be formed by, for example, printing silver paste at p type region 111 and n type region 112, followed by firing at, for example, 500°C to 700°C. Thus, a back surface contact type solar cell having the back surface shown in Fig. 1 is produced.

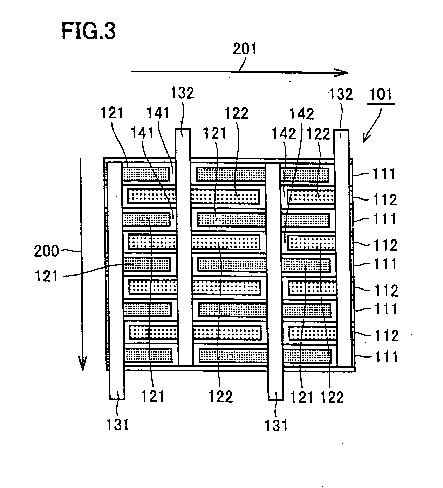

The obtained back surface contact type solar cell having the back surface of Fig. 1 is connected to first and second interconnectors 131 and 32 shown in Fig. 3 and the like, that will be described afterwards. The material and configuration of the interconnector are not particularly limited as long as the conductive requirement is satisfied. Preferably, the interconnector is formed of a conductor taking a strip shape, such as a foil or plate. Connection can be established relatively readily by virtue of the interconnector. In the case where the interconnector takes a strip shape, the interconnector preferably has a width of approximately 0.5 mm to 5 mm, and a thickness of approximately 0.05 mm to 0.5 mm.

The interconnector includes various metals, alloy, and the like; for example, the metal of Au, Ag, Cu, Pt, Al, Ni and Ti, or an alloy thereof. Particularly, Cu is preferable. Further, the interconnector is preferably coated with solder. A solder-coated interconnector is apt to improve the reliability of the connection with the electrodes of the back surface contact type solar cell. The electrode directed to connection in the back surface contact type solar cell can be connected with the solder-coated interconnector by, for example, heating through a heater, through a lamp, the reflow scheme, or the like.

An exemplified arrangement of the interconnectors is as shown in the schematic plan view of Fig. 3. First interconnector 131 of a strip shape is arranged to electrically connect finger p electrodes 121 adjacent in the direction of arrow 200 shown in Fig. 3 (aligning direction of p type region 111 and n type region 112) with each other. Second interconnector 132 of a strip shape is arranged to electrically connect finger n electrodes 122 adjacent in the direction of arrow 200 shown in Fig. 3 (aligning direction of p type region 111 and n type region 112) with each other. In other words, first and second interconnectors 131 and 132 are connected such that the longitudinal direction of each connector corresponds to the direction of arrow 200 shown in Fig. 3.

At the back surface of silicon substrate 101, the region between finger p electrodes 121 adjacent in the direction of arrow 200 shown in Fig. 3 is identified as a second non-connection region 142 where a finger n electrode 122 is not formed. Therefore, first interconnector 131 is not electrically connected with finger n electrode 122, and serves to electrically connect finger p electrodes 121 adjacent in the direction of arrow 200 shown in Fig. 3 with each other.

Similarly, the region between finger n electrodes 122 adjacent in the direction of arrow 200 shown in Fig. 3 is identified as a first non-connection region 141 where a finger p electrode 121 is not formed. Therefore, second interconnector 132 is not electrically connected with finger p electrode 121, and serves to electrically connect finger n electrodes 122 adjacent in the direction of arrow 200 shown in Fig. 3 with each other.

The back surface contact type solar cell based on the configuration set forth above can have the characteristics improved, as compared to the conventional back surface contact type solar cell shown in Figs. 9 and 10. This may be attributed to the increase of the pn junction region at the back surface of n type silicon substrate 101 since formation of a bus bar p electrode 123 for electrically connecting finger p electrodes 121 with each other and a bus bar n electrode 124 for electrically connecting finger n electrodes 122 with each other is dispensable, and to the reduction in the series resistance since the length of each of finger p electrode 121 and finger n electrode 122 can be shortened as compared to those in the conventional back surface contact type solar cell shown in Figs. 9 and 10.

The back surface contact type solar cell of the configuration set forth above includes a first non-connection region 141 where finger p electrode 121 is not formed on p type region 111, and a second non-connection region 142 where finger n electrode 122 is not formed on n type region 112.

Therefore, the connection of first interconnector 131 and second interconnector 132 can be established relatively readily since short-circuiting is eliminated even though first interconnector 131 qualified as wiring for p type runs above second non-connection region 142 in n type region 112, and second interconnector 132 qualified as wiring for n type runs above first non-connection region 141 in p type region 111. Thus, production of a back surface contact type solar cell is facilitated.

Moreover, the production of finger p electrode 121 and finger n electrode 122 is facilitated by a virtue of the configuration in which the strips of a finger p electrode 121 and finger n electrode 122 are formed intermittently in the direction of arrow 201 shown in Fig. 3 in the present embodiment.

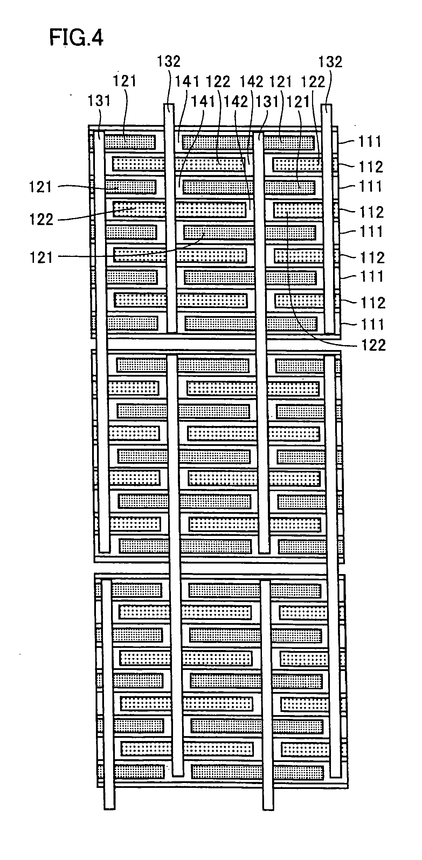

Fig. 4 represents a schematic plan view of a back surface according to an example of a solar cell string having the back surface contact type solar cells of the present invention electrically connected. The solar cell string of Fig. 4 is based on a configuration in which the other end of first interconnector 131 electrically connected to finger p electrode 121 in the back surface contact type solar cell of Fig. 3 is electrically connected to finger n electrode 122 of another back surface contact type solar cell having a back surface similar to that of Fig. 3, and the other end of second interconnector 132 electrically connected to finger n electrode 122 of the back surface contact type solar cell shown in Fig. 3 is electrically connected to finger p electrode 121 of another back surface contact type solar cell having a back surface similar to that of Fig. 3.

Since the effect of improvement in the characteristics of a back surface contact type solar cell described above is exhibited in each of the back surface contact type solar cells constituting the solar cell string of the configuration set forth above, it is considered that the characteristics of the solar cell string of the present invention is improved synergistically as compared to a conventional solar cell string having conventional back surface contact type solar cells shown in Figs. 9 and 10 electrically connected.

In the back surface contact type solar cell constituting the aforementioned solar cell string, first non-connection region 141 impeding electrical connection with finger p electrode 121 is formed on p type region 111, and second non-connection region 142 impeding electrical connection with finger n electrode 122 is formed on n type region 112. Therefore, the connection of back surface contact type solar cells with each other by first interconnector 131 and second interconnector 132 can be facilitated since short-circuiting is eliminated even though first interconnector 131 qualified as wiring for p type runs above second non-connection region 142 in n type region 112 and second interconnector 132 qualified as wiring for n type runs above first non-connection region 141 in p type region 111. Thus, production of a solar cell string is facilitated.

By sealing the solar cell string shown in Fig. 4 in resin or the like based on a conventionally known method, a solar cell module of the present invention can be produced. For example, solar cell strings are connected in series together using a relatively thick wiring member called "bus bar", as necessary. These connected solar cell strings are sandwiched between EVA (ethylene vinyl acetate) films serving as the sealing material. Then, this EVA film is further sandwiched between a glass plate that is a surface protection layer and a back side film constituted of acrylic resin or the like. The voids introduced between the EVA films are eliminated by reducing the pressure (laminate), followed by heating (cure) to cause the EVA to harden. Thus, the back surface contact type solar cell is sealed. Then, an aluminium frame is fitted along the outer circumference, and a terminal box is connected to a pair of external terminals extending outwards. Thus a solar cell module is completed.

Since the effect of improvement in the characteristics of each of the back surface contact type solar cells constituting the solar cell module is exhibited in the solar cell module of the present invention, the characteristics of the solar cell module is improved synergistically as compared to a conventional solar cell module having conventional back surface contact type solar cells shown in Figs. 9 and 10 electrically connected. Moreover, production of a solar cell module is facilitated since connection of back surface contact type solar cells constituting the solar cell module is also facilitated.

In the back surface contact type solar cell, the solar cell string, and the solar cell module of the present embodiment, first interconnector 131 and second interconnector 132 taking a strip shape are connected in a direction orthogonal to finger p electrode 121 and finger n electrode 122 in strip form. It is therefore considered that the series resistance is reduced, in addition to facilitating connection of first interconnector 131 and second interconnector 132 (that is, improvement in characteristics).

### <Second Embodiment>

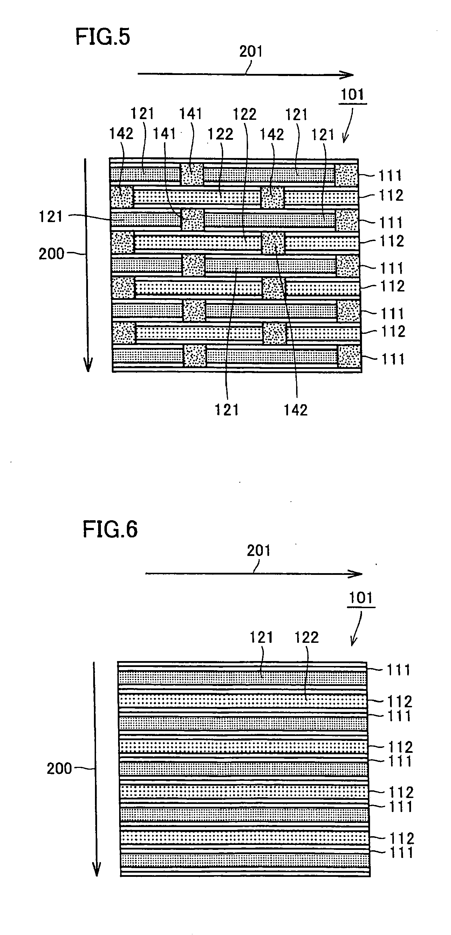

Fig. 5 represents a schematic plan view of a back surface according to another example of a back surface contact type solar cell of the present invention. The back surface contact type solar cell of Fig. 5 is **characterized in that** rectangular first non-connection regions 141 having an insulation layer formed on each surface of strip-like finger p electrodes 121 adjacent in the direction of arrow 200 shown in Fig. 5 (the aligning direction of p type region 111 and n type region 112) are aligned linearly, whereas rectangular second non-connection regions 142 having an insulation layer formed on each surface of strip finger n electrodes 122 adjacent in the direction of arrow 200 shown in Fig. 5 (the aligning direction of p type region 111 and n type region 112) are aligned linearly. Two first non-connection regions 141 are formed per one finger p electrode 121, spaced apart by a predetermined distance along the direction of arrow 201 shown in Fig. 5 (longitudinal direction of finger p electrode 121). Furthermore, two second non-connection regions 142 are formed per one finger n electrode 122, spaced apart by a predetermined distance along the direction of arrow 201 shown in Fig. 5 (longitudinal direction of finger p electrode 121). The number, position, shape and the like of first and second non-connection regions 141 and 142 are not limited to those of the configuration shown in Fig. 5.

An example of a method for fabricating a back surface contact type solar cell of Fig. 5 will be described hereinafter. Likewise with the first embodiment, the steps of (a)-(g) in Fig. 2 are sequentially carried out. At the step shown in Fig. 2(h), contact hole 107 is formed corresponding to the shape of finger p electrode 121 shown in the schematic plan view of Fig. 6, and contact hole 108 is formed corresponding to the shape of finger n electrode 122 shown in Fig. 6.

As shown in Fig. 2(i), finger p electrode 121 and finger n electrode 122 are formed on the surface of p type region 111 and n type region 112, respectively, exposed at contact holes 107 and 108, respectively, likewise with the first embodiment.

Then, an insulation layer is formed on respective surfaces of finger p electrode 121 and finger n electrode 122 located at the position where first non-connection region 141 and second non-connection region 142, respectively, shown in Fig. 5, are formed. The insulation layer can be formed by applying insulation paste on respective surfaces of finger p electrode 121 and finger n electrode 122, followed by drying. Thus, first and second non-connection regions 141 and 142 shown in Fig. 5 are formed.

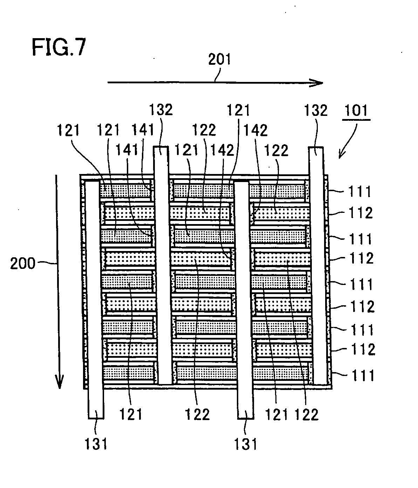

Likewise with the first embodiment, the back surface contact type solar cell having a back surface shown in Fig. 5, obtained as set forth above, has an interconnector connected thereto. The interconnectors are arranged such that, as shown in the schematic plan view of Fig. 7 for example, first interconnector 131 of a strip form electrically connects finger p electrodes 121 adjacent in the direction of arrow 200 shown in Fig. 7 (the aligning direction of p type region 111 and n type region 112) with each other, and second interconnector 132 of a strip form electrically connects finger n electrodes 122 adjacent in the direction of arrow 200 shown in Fig. 7 (the aligning direction of p type region 111 and n type region 112) with each other. Namely, first interconnector 131 and second interconnector 132 are connected such that the longitudinal direction of each connector corresponds to the direction of arrow 200 shown in Fig. 7.

At the back surface of n type silicon substrate 101, the region between finger p electrodes 121 adjacent in the direction of arrow 200 of Fig. 7 is identified as second non-connection region 142 having an insulation layer formed at the surface of finger n electrode 122. Therefore, first interconnector 131 is not electrically connected with finger n electrode 122, and serves to electrically connect finger p electrodes 121 adjacent in the direction of arrow 200 shown in Fig. 7 with each other.

Similarly, since the region between finger n electrodes 122 adjacent in the direction of arrow 200 shown in Fig. 7 is identified as first non-connection region 141 having an insulation layer formed at the surface of finger p electrode 121, second interconnector 132 is not electrically connected with finger p electrode 121, and serves to electrically connect finger n electrodes 122 adjacent in the direction of arrow 200 shown in Fig. 7 with each other.

The back surface contact type solar cell of such a configuration can have the characteristics improved, as compared to the conventional back surface contact type solar cell shown in Figs. 9 and 10. This may be attributed to the fact that it is not necessary to form a bus bar p electrode 123 for electrically connecting finger p electrodes 121 with each other and to form a bus bar n electrode 124 for electrically connecting finger n electrodes 122 with each other, as in the conventional back surface contact type solar cell shown in Figs. 9 and 10, which in turn allows increase of the pn junction region at the back surface of n type silicon substrate 101.

At the back surface contact type solar cell of the configuration set forth above, a first non-connection region 141 impeding electrical connection with finger p electrode 121 is formed on p type region 111, and a second non-connection region 142 impeding electrical connection with finger n electrode 122 is formed on n type region 112.

Therefore, the connection of first interconnector 131 and second interconnector 132 can be established relatively readily since short-circuiting is eliminated even though first interconnector 131 qualified as wiring for p type runs above second non-connection region 142 in n type region 112, and second interconnector 132 qualified as wiring for n type runs above first non-connection region 141 in p type region 111. Thus, production of a back surface contact type solar cell is facilitated.

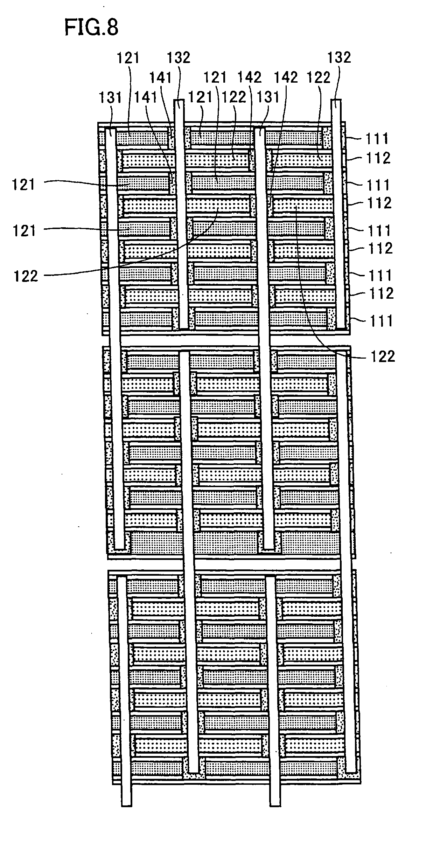

Fig. 8 represents a schematic plan view of a back surface according to an example of a solar cell string having the back surface contact type solar cells of the present invention electrically connected. The solar cell string of Fig. 8 is based on a configuration in which the other end of first interconnector 131 electrically connected to finger p electrode 121 in the back surface contact type solar cell of Fig. 7 is electrically connected to finger n electrode 122 of another back surface contact type solar cell having a back surface similar to that of Fig. 7, and the other end of second interconnector 132 electrically connected to finger n electrode 122 of the back surface contact type solar cell shown in Fig. 7 is electrically connected to finger p electrode 121 of another back surface contact type solar cell having a back surface similar to that of Fig. 7.

Since the advantage of improvement in the characteristics of a back surface contact type solar cell described above is exhibited in each of the back surface contact type solar cells constituting the solar cell string of the configuration set forth above, it is considered that the characteristics of the solar cell string of the present invention is improved synergistically, as compared to a conventional solar cell string having conventional back surface contact type solar cells shown in Figs. 9 and 10 electrically connected.

In the back surface contact type solar cell constituting the aforementioned solar cell string, first non-connection region 141 impeding electrical connection with finger p electrode 121 is formed on p type region 111, and second non-connection region 142 impeding electrical connection with finger n electrode 122 is formed on n type region 112. Therefore, the connection of back surface contact type solar cells with each other by first interconnector 131 and second interconnector 132 can be facilitated since short-circuiting is eliminated even though first interconnector 131 qualified as wiring for p type runs above second non-connection region 142 in n type region 112 and second interconnector 132 qualified as wiring for n type runs above first non-connection region 141 in p type region 111. Thus, production of a solar cell string is facilitated.

By sealing the solar cell string shown in Fig. 8 in resin or the like based on a conventionally known method, likewise with the first embodiment, a solar cell module of the present invention can be produced. Since the advantage of improvement in the characteristics of a back surface contact type solar cell described above is exhibited in each of the back surface contact type solar cells constituting the solar cell string of the configuration set forth above, the characteristics of the solar cell module of the present invention is improved synergistically, as compared to a conventional solar cell module having conventional back surface contact type solar cells shown in Figs. 9 and 10 electrically connected. Thus, production of a solar cell module is facilitated.

The back surface contact type solar cell, solar cell string, and solar cell module of the present embodiment has first and second interconnectors 131 and 132 of strip form connected in a direction orthogonal to the longitudinal direction of strip-like finger p electrode 121 and finger n electrode 122. Therefore, it is considered that not only connection of first and second interconnectors 131 and 132 is facilitated, but also the series resistance is reduced (improvement of characteristics).

### <Third Embodiment>

An example of a back surface contact type solar cell with a wiring board of the present invention will be described hereinafter. A back surface contact type solar cell with a wiring board of the present invention includes at least a back surface contact type solar cell set forth above, and a wiring board having an insulative substrate and a conductive wiring member formed on the surface of the insulative substrate.

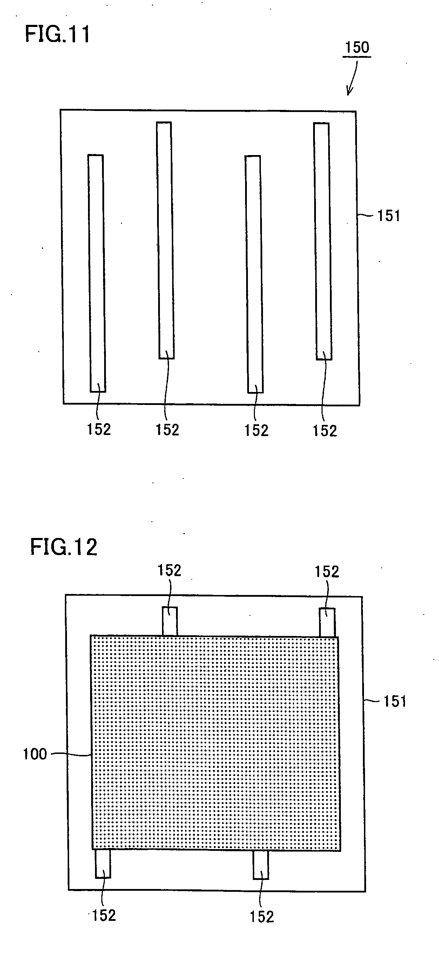

Fig. 11 represents a schematic plan view of an example of a wiring board employed in a back surface contact type solar cell with a wiring board of the present invention. A wiring board 150 includes, as shown in Fig. 11 for example, at least an insulative substrate 151 and a conductive wiring member 152 formed on the surface of insulative substrate 151.

The substance of insulative substrate 151 is not particularly limited, as long as it is insulative. For example, at least one of polyimide and polyethylene terephthalate (PET) can be employed.

The substance of wiring member 152 is not particularly limited as long as it is conductive. For example, copper or the like can be employed.

Fig. 12 represents a schematic plan view of a light receiving face of a back surface contact type solar cell with a wiring board of the present invention. The back surface contact type solar cell with a wiring board of the present invention is configured having a back surface contact type solar cell 100 of the present invention disposed on wiring member 152 of wiring board 150, as shown in Fig. 12 for example.

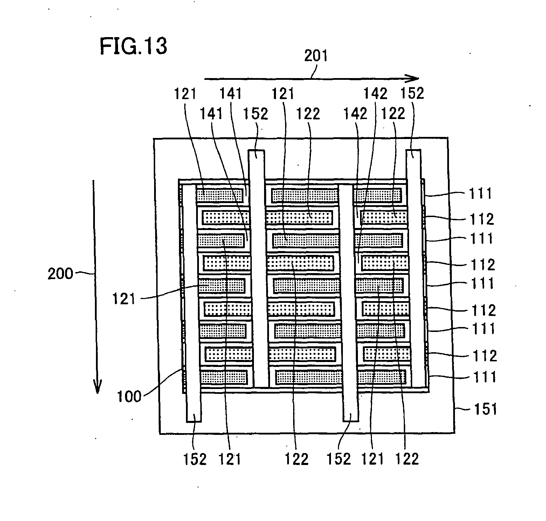

Fig. 13 represents a schematic plan view of a back surface of an exemplified back surface contact type solar cell with a wiring board of Fig. 12. The back surface contact type solar cell with a wiring board of the present invention includes, at the back side, a plurality of finger p electrodes 121 serving as the electrode for first conductivity type, and a plurality of finger n electrodes 122 identified as the electrode for second conductivity type.

In the back surface contact type solar cell with a wiring board of the present invention, finger p electrodes 121 are electrically connected with each other by wiring member 152 of wiring board 150, and finger n electrodes 122 are electrically connected with each other by a wiring member 152 differing from wiring member 152 that electrically connects finger p electrodes 121 with each other, as shown in Fig. 13, for example.

The back surface contact type solar cell with a wiring board based on the configuration set forth above can have the characteristics improved, as compared to the conventional back surface contact type solar cell shown in Figs. 9 and 10. This may be attributed to the increase of the pn junction region at the back surface of back surface contact type solar cell 100 since formation of a bus bar p electrode 123 for electrically connecting finger p electrodes 121 with each other and a bus bar n electrode 124 for electrically connecting finger n electrodes 122 with each other is dispensable, and to the reduction in the series resistance since the length of each of finger p electrode 121 and finger n electrode 122 can be shortened, as compared to those in the conventional back surface contact type solar cell shown in Figs. 9 and 10.

The back surface contact type solar cell with a wiring board of the configuration set forth above includes a first non-connection region 141 where finger p electrode 121 is not formed on p type region 111, and a second non-connection region 142 where finger n electrode 122 is not formed on n type region 112.

In the back surface contact type solar cell with a wiring board of the above-described configuration, wiring member 152 electrically connecting finger p electrodes 121 with each other runs above second non-connection region 142 at n type region 112, impeding electrical connection with finger n electrode 122. Further, wiring member 152 electrically connecting finger n electrodes 122 with each other runs above first non-connection region 141 at p type region 111, impeding electrical connection with finger p electrode 121. Therefore, the production and connection of wiring member 152 are facilitated since wiring member 152 of a simple configuration such as a strip may be produced and disposed on finger p electrode 121 and finger n electrode 122 of back surface contact type solar cell 100. Thus, production of a back surface contact type solar cell with a wiring board is facilitated.

Furthermore, since strip-like finger p electrode 121 and finger n electrode 122 are to be formed intermittently in the direction of arrow 201 shown in Fig. 13 in the back surface contact type solar cell with a wiring board of the above-described configuration, the production of finger p electrode 121 and finger n electrode 122 per se is facilitated.

Another example of a solar cell string of the present invention will be described hereinafter. This another example of a solar cell string of the present invention includes at least a plurality of back surface contact type solar cells set forth above, and a wiring board having an insulative substrate and a conductive wiring member formed on the surface of the insulative substrate.

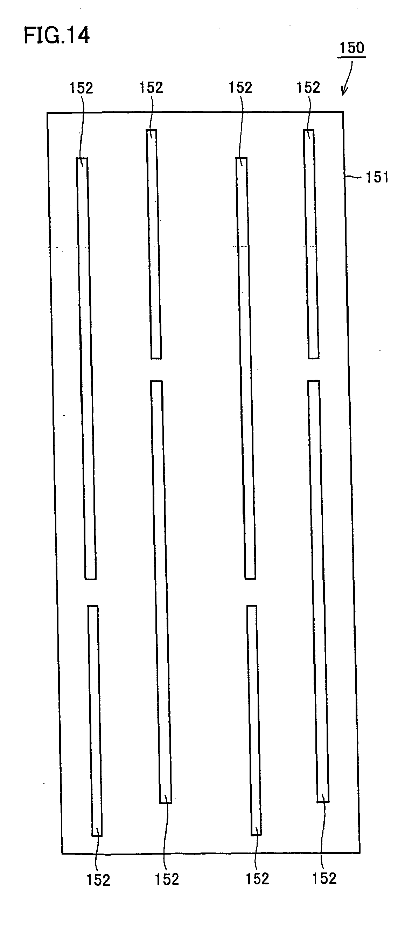

Fig. 14 represents a schematic plan view of an example of a wiring board employed in the another example of a solar cell string of the present invention. Wiring board 150 includes, as shown in Fig. 14, for example, at least an insulative substrate 151, and a conductive wiring member 152 of a strip shape, formed intermittently on the surface of insulative substrate 151.

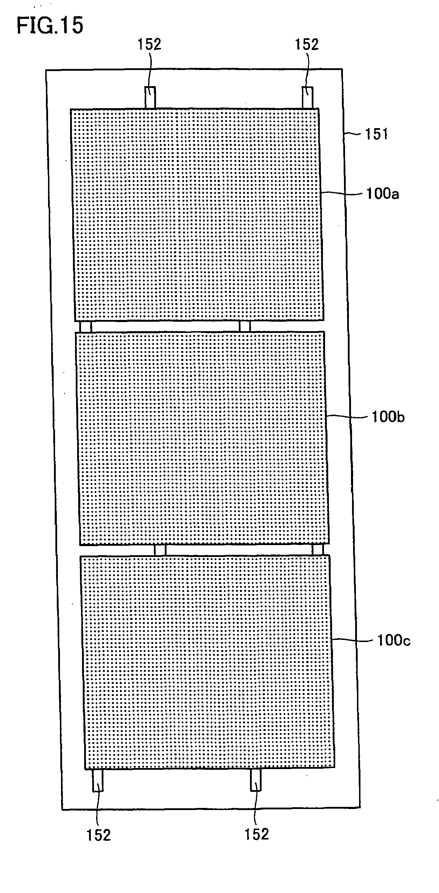

Fig. 15 represents a schematic plan view of a light receiving face of the another solar cell string of the present invention. This another solar cell string of the present invention has, as shown in Fig. 15, for example, back surface contact type solar cells 100a, 100b and 100c of the present invention aligned on wiring member 152 of wiring board 150.

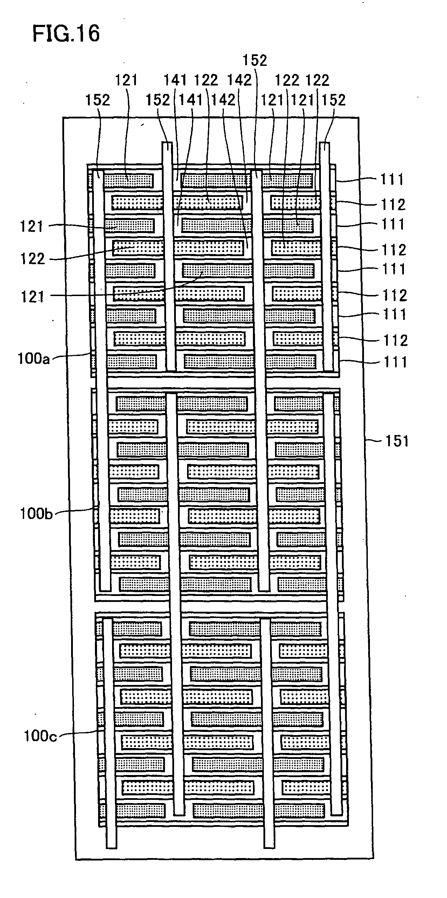

Fig. 16 represents a schematic plan view of a back surface of the solar cell string of Fig. 15. The solar cell string of Fig. 16 includes, at respective back surfaces of the plurality of back surface contact type solar cells 100a, 100b, and 100c, a plurality of finger p electrodes 121 identified as the electrode for first conductivity type, and a plurality of finger n electrodes 122 identified as the electrode for second conductivity type.

At each of the plurality of back surface contact type solar cells 100a, 100b, and 100c, finger p electrodes 121 are electrically connected with each other by wiring member 152, and finger n electrodes 122 are electrically connected with each other by wiring member 152.

In back surface contact type solar cell 100a that is one of the plurality of back surface contact type solar cells 100a, 100b, and 100c, wiring member 152 electrically connecting finger p electrodes 121 with each other is also a wiring member 152 electrically connecting finger n electrodes 122 of another back surface contact type solar cell 100b adjacent to back surface contact type solar cell 100a with each other.

In back surface contact type solar cell 100b that is one of the plurality of back surface contact type solar cells 100a, 100b, and 100c, wiring member 152 electrically connecting finger p electrodes 121 with each other is also a wiring member 152 electrically connecting finger n electrodes 122 of another back surface contact type solar cell 100c adjacent to back surface contact type solar cell 100b with each other.

Further, in back surface contact type solar cell 100b that is one of the plurality of back surface contact type solar cells 100a, 100b, and 100c, wiring member 152 electrically connecting finger n electrodes 122 with each other is also a wiring member 152 electrically connecting finger p electrodes 121 of another back surface contact type solar cell 100a adjacent to back surface contact type solar cell 100b with each other.

Moreover, in back surface contact type solar cell 100c that is one of the plurality of back surface contact type solar cells100a, 100b, and 100c, wiring member 152 electrically connecting finger n electrodes 122 with each other is also a wiring member 152 electrically connecting finger p electrodes 121 of another back surface contact type solar cell 100b adjacent to back surface contact type solar cell 100c with each other.

In a solar cell string of such a configuration, the advantage of improving characteristics of the back surface contact type solar cell described above is exhibited at respective back surface contact type solar cells constituting the solar cell string. Therefore, the characteristics of the solar cell string of the present invention is improved synergistically, as compared to a conventional solar cell string having conventional back surface contact type solar cells shown in Figs. 9 and 10 electrically connected.

The solar cell string of the above-described configuration can be produced by just disposing back surface contact type solar cells 100a, 100b, and 100c on wiring members 152 of the wiring board. Therefore, production of a solar cell string is facilitated.

Furthermore, by sealing the solar cell string shown in Fig. 16 in resin or the like based on a conventionally known method, a solar cell module of the present invention can be produced. For example, solar cell strings are connected in series together using a relatively thick wiring member called "bus bar", as necessary. These connected solar cell strings are sandwiched between EVA (ethylene vinyl acetate) films serving as the sealing material. Then, this EVA film is further sandwiched between a glass plate that is a surface protection layer and a back side film constituted of acrylic resin or the like. The voids introduced between the EVA films are eliminated by reducing the pressure (laminate), followed by heating (cure) to cause the EVA to harden. Thus, the back surface contact type solar cell is sealed. Then, an aluminium frame is fitted along the outer circumference, and a terminal box is connected to a pair of external terminals extending outwards. Thus a solar cell module is completed.

Since the effect of improvement in the characteristics of each of the back surface contact type solar cells constituting the solar cell module is exhibited in the solar cell module of the present invention, the characteristics of the solar cell module is improved synergistically, as compared to a conventional solar cell module having conventional back surface contact type solar cells shown in Figs. 9 and 10 electrically connected. Moreover, production of a solar cell module is facilitated since mutual connection of back surface contact type solar cells constituting the solar cell module is also facilitated.

In the back surface contact type solar cell with a wiring board, the solar cell string, and the solar cell module of the present embodiment, the wiring members taking a strip shape are connected in a direction orthogonal to the longitudinal direction of the finger p electrode and finger n electrode in strip form by just arranging the above-described back surface contact type solar cells on the wiring member of the wiring board. It is therefore considered that the series resistance is reduced, in addition to facilitating connection (that is, improvement in characteristics).

The descriptions other than those set forth above in the present third embodiment are similar to those of the first embodiment. Therefore, the same description will not be repeated here.

### <Fourth Embodiment>

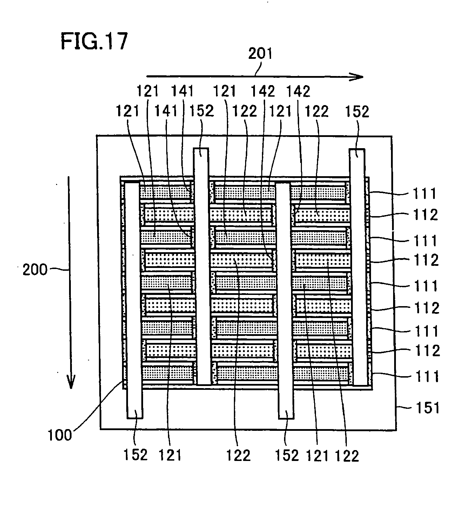

Fig. 17 represents a flat plan view of the back surface of another example of a back surface contact type solar cell with a wiring board of the present invention. The back surface contact type solar cell with a wiring board of the present invention based on the configuration of Fig. 17 differs from the third embodiment in that a back surface contact type solar cell 100 of a configuration described in the second embodiment is employed.

A back surface contact type solar cell with a wiring board of such a configuration can have the characteristics improved, as compared to a conventional back surface contact type solar cell shown in Figs. 9 and 10. This may be attributed to the increase of the pn junction region at the back surface of back surface contact type solar cell 100 since formation of a bus bar p electrode 123 for electrically connecting finger p electrodes 121 with each other and a bus bar n electrode 124 for electrically connecting finger n electrodes 122 with each other is dispensable, and to the reduction in the series resistance since the length of each of finger p electrode 121 and finger n electrode 122 can be shortened as compared to those in the conventional back surface contact type solar cell shown in Figs. 9 and 10.

The back surface contact type solar cell with a wiring board of the above-described configuration includes a first non-connection region 141 that is a rectangular region having an insulation layer formed on p type region 111, and a second non-connection region 142 that is a rectangular region having an insulation layer formed on n type region 112.

In the back surface contact type solar cell with a wiring board of the above-described configuration, wiring member 152 electrically connecting finger p electrodes 121 with each other runs above second non-connection region 142 at n type region 112, impeding electrical connection with finger n electrode 122. Further, wiring member 152 electrically connecting finger n electrodes 122 with each other runs above first non-connection region 141 at p type region 111, impeding electrical connection with finger p electrode 121. Therefore, the production and connection of wiring member 152 are facilitated since wiring member 152 of a simple configuration such as a strip may be produced and disposed on finger p electrode 121 and finger n electrode 122 of back surface contact type solar cell 100. Thus, production of a back surface contact type solar cell with a wiring board is facilitated.

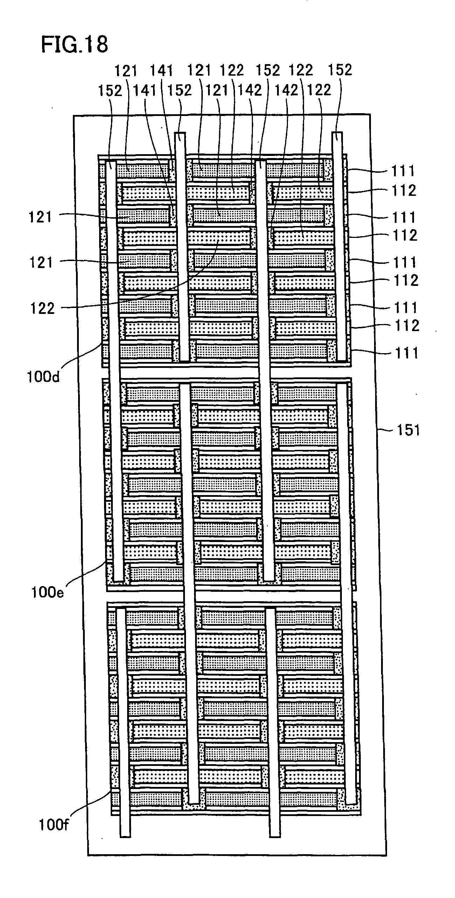

Fig. 18 represents a schematic plan view of a back surface of another solar cell string of the present invention. This another example of a solar cell string of the present invention includes a plurality of back surface contact type solar cells 100d, 100e, and 100f arranged in alignment on wiring member 152 of wiring board 150, as shown in Fig. 18, for example. At respective back surfaces of the plurality of back surface contact type solar cells 100d, 100e, and 100f, a plurality of finger p electrodes 121 identified as the electrode for first conductivity type, and a plurality of finger n electrodes 122 identified as the electrode for second conductivity type are provided.

At each of the plurality of back surface contact type solar cells 100d, 100e, and 100f, finger p electrodes 121 are electrically connected with each other by wiring member 152, and finger n electrodes 122 are electrically connected with each other by wiring member 152.

In back surface contact type solar cell 100d that is one of the plurality of back surface contact type solar cells 100d, 100e, and 100f, wiring member 152 electrically connecting finger p electrodes 121 with each other is also a wiring member 152 electrically connecting finger n electrodes 122 of another back surface contact type solar cell 100e adjacent to back surface contact type solar cell 100d with each other.

In back surface contact type solar cell 100e that is one of the plurality of back surface contact type solar cells 100d, 100e, and 100f, wiring member 152 electrically connecting finger p electrodes 121 with each other is also a wiring member 152 electrically connecting finger n electrodes 122 of another back surface contact type solar cell 100e adjacent to back surface contact type solar cell 100e with each other.

Further, in back surface contact type solar cell 100e that is one of the plurality of back surface contact type solar cells 100d, 100e, and 100f, wiring member 152 electrically connecting finger n electrodes 122 with each other is also a wiring member 152 electrically connecting finger p electrodes 121 of another back surface contact type solar cell 100d adjacent to back surface contact type solar cell 100e with each other.

Moreover, in back surface contact type solar cell 100f that is one of the plurality of back surface contact type solar cells 100d, 100e, and 100f, wiring member 152 electrically connecting finger n electrodes 122 with each other is also a wiring member 152 electrically connecting finger p electrodes 121 of another back surface contact type solar cell 100e adjacent to back surface contact type solar cell 100f with each other.

In a solar cell string of such a configuration, the advantage of improving characteristics of the back surface contact type solar cell described above is exhibited at respective back surface contact type solar cells constituting the solar cell string. Therefore, the characteristics of the solar cell string of the present invention is improved synergistically, as compared to a conventional solar cell string having conventional back surface contact type solar cells shown in Figs. 9 and 10 electrically connected.

The solar cell string of the above-described configuration can be produced by just disposing back surface contact type solar cells 100d, 100e, and 100f on wiring members 152 of the wiring board. Therefore, production of a solar cell string is facilitated.

Furthermore, by sealing the solar cell string shown in Fig. 18 in resin or the like based on a conventionally known method, a solar cell module of the present invention can be produced. For example, solar cell strings are connected in series together, using a relatively thick wiring member called "bus bar", as necessary. These connected solar cell strings are sandwiched between EVA (ethylene vinyl acetate) films serving as the sealing material. Then, this EVA film is further sandwiched between a glass plate that is a surface protection layer and a back side film constituted of acrylic resin or the like. The voids introduced between the EVA films are eliminated by reducing the pressure (laminate), followed by heating (cure) to cause the EVA to harden. Thus, the back surface contact type solar cell is sealed. Then, an aluminium frame is fitted along the outer circumference, and a terminal box is connected to a pair of external terminals extending outwards. Thus a solar cell module is completed.

Since the effect of improvement in the characteristics of each of the back surface contact type solar cells constituting the solar cell module is exhibited in the solar cell module of the present invention, the characteristics of the solar cell module is improved synergistically, as compared to a conventional solar cell module having conventional back surface contact type solar cells shown in Figs. 9 and 10 electrically connected. Moreover, production of a solar cell module is facilitated since mutual connection of back surface contact type solar cells constituting the solar cell module is also facilitated.

In the back surface contact type solar cell with a wiring board, the solar cell string, and the solar cell module of the present embodiment, the wiring members taking a strip shape are connected in a direction orthogonal to the longitudinal direction of the finger p electrode and finger n electrode in strip form by just arranging the above-described back surface contact type solar cells on the wiring member of the wiring board. It is therefore considered that the series resistance can be reduced, in addition to facilitating connection (that is, improvement in characteristics).

The descriptions other than those set forth above in the present fourth embodiment are similar to those of the second and third embodiments. Therefore, the same description will not be repeated here.

### (Miscellaneous)

In the above-described first to fourth embodiments, a silicon substrate is employed for the semiconductor substrate. The present invention is not restricted to a silicon substrate for the semiconductor substrate.

Further, the conductivity of the n type and p type may be exchanged in the first to fourth embodiments. In the case where an n type silicon substrate is employed for the semiconductor substrate, pn junction is formed by the p type region at the back side of the n type silicon substrate and that n type silicon substrate. In the case where a p type silicon is employed for the semiconductor substrate, pn junction is formed by the n type region at the back side of the p type silicon substrate and that p type silicon substrate.

In the present invention, as shown in the back face pattern of Fig. 1 and the back face pattern shown in Fig. 5, the shape of the electrode for first conductivity type and the electrode for second conductivity type is preferably identical or symmetric before and after rotation, when the semiconductor substrate is rotated 180° with the axis orthogonal to the back surface of the semiconductor substrate as an axis of rotation. In this case, when the plurality of back surface contact type solar cells of the present invention are connected by means of strip-like first and second interconnectors, each one of the back surface contact type solar cells can be aligned while being rotated 180° to allow connection readily by the strip-like first and second interconnectors. Therefore, production of a solar cell string and solar cell module of straight wiring is facilitated.

When the semiconductor substrate is of the n type in the present invention, the area of the p type region at the back surface of the semiconductor substrate is preferably larger than the area of the n type region. When the semiconductor substrate is of a p type, the area of the n type region at the back surface of the semiconductor substrate is preferably larger than the area of the p type region. This is advantageous in that the characteristics of the back surface contact type solar cells of the present invention can be improved.

Particularly, a back surface contact type solar cell corresponding to the case where the semiconductor substrate is of the n type and the area of the p type region at the back surface of the semiconductor substrate is larger than the area of the n type region is preferable since the characteristics of the back surface contact type solar cell of the present invention can be further improved.

### (Example 1)

A back surface contact type solar cell having the back surface shown in Fig. 1 was produced. For this back surface contact type solar cell, a 125 mm × 125 mm square silicon substrate was used to produce a solar cell having a surface of 120 mm × 100 mm. The width of an n type region and a p type region formed by diffusing n type impurities and p type impurities, respectively, at the back surface of the silicon substrate of the back surface contact type solar cell was 300 µm and 1000 µm, respectively. The pitch between the n type region and p type region was 1.5 mm. The width of the finger n electrode and finger p electrode in contact with the n type region and p type region, respectively, was 200 µm and 400 µm, respectively. The pitch between a finger n electrode and a finger p electrode was 1.5 mm.

First, an n type monocrystalline silicon substrate having a square surface of 125 mm × 125 mm was prepared. Any slice damage was removed by etching with a solution containing 48% of sodium hydroxide in concentration. The temperature of the solution was 100°C.

Then, as a texture mask at the back surface of the silicon substrate, a silicon oxide film of 700 nm in thickness was formed by APCVD (Atmospheric Pressure Chemical Vapor Deposition), followed by forming a texture structure at the light receiving face of the silicon substrate. The texture structure was obtained by etching the light receiving face of the silicon substrate using a solution heated in the vicinity of 80°C. This solution was a mixture of isopropyl alcohol added to a solution containing 3% of potassium hydroxide in concentration. Then, the silicon substrate was immersed for 200 seconds in a hydrofluoric solution having a hydrofluoric concentration of 50% to remove the texture mask.

Next, a first diffusion mask constituted of a silicon oxide film was formed to a thickness of 250 nm all over the light receiving face and back surface of the silicon substrate by APCVD. Etching paste including phosphorus acid as an etching component (paste based on a mixture of water and thickener into a solution containing 30% of phosphorus acid in concentration, having the viscosity adjusted to allow printing) was screen-printed on a region of the first diffusion mask corresponding to the formation region of a p type region at the back surface of the silicon substrate. By heating the silicon substrate to 350°C using a hot plate, the portion of the first diffusion mask having etching paste printed thereon was removed to form a window, causing a portion of the back face of the silicon substrate to be exposed. Then, the silicon substrate was immersed in water, and ultrasonic waves were applied thereto for ultrasonic cleaning.

A PBF solution (3M-31 made by Tokyo Ohkakogyo Co., Ltd.) was applied to the back surface of silicon substrate exposed at the window and dried, followed by a heat treatment for 50 minutes at 970°C to form a p type region. Subsequently, the first diffusion mask and BSG formed by diffusing boron (boron silicate glass) were completely removed using a hydrofluoric solution.

Similar to the first diffusion mask, a second diffusion mask constituted of a silicon oxide film was provided all over the light receiving face and back surface of the silicon substrate. The portion of the second diffusion mask corresponding to the formation region of an n type region at the back surface of the silicon substrate was removed in a manner similar to that of the formation of the p type region to form a window. Thus, a portion of the back surface of the silicon substrate was exposed.

The back surface of the silicon substrate exposed at the window was subjected to an atmosphere including POCl₃ at 890°C for 20 minutes to cause phase diffusion of phosphorus to form an n type region. Subsequently, the second diffusion mask and PSG (Phosphorus Silicate Glass) formed by diffusion of phosphorus were completely removed using a hydrofluoric solution.

Next, the silicon substrate was subjected to dry oxidation (thermal oxidation) to form a passivation film constituted of a silicon oxide film over the entire back surface of the silicon substrate. Following complete removal of the silicon oxide film from the light receiving face of the silicon substrate using a hydrofluoric solution, an anti-reflection film constituted of a silicon nitride film having a refractive index of 2.1 was deposited by plasma CVD. Then, annealing was carried out for 15 minutes in a nitrogen atmosphere at 415°C, having 3% of hydrogen mixed.

Likewise with the formation of a window, etching paste was printed on a region of the passivation film corresponding to the formation regions of a p type region and n type region, followed by heat treatment. The silicon substrate subjected to heating was immersed in water, and ultrasonic waves were applied for ultrasonic cleaning. Accordingly, the passivation film was partially removed to form a contact hole, exposing a portion of respective surfaces of the p type region and n type region.

Finally, silver paste was printed on respective surfaces of the p type region and n type region exposed at the contact holes, followed by firing at 650°C to form a finger p electrode and a finger n electrode in contact with a p type region and an n type region, respectively. The silicon substrate was diced to the size of 120 mm × 100 mm to obtain a back surface contact type solar cell.

Thus, a back surface contact type solar cell based on a configuration in which first interconnector 131 and second interconnector 132 were connected, as shown in Fig. 3, to finger p electrode 121 and finger n electrode 122, respectively, of the back surface contact type solar cell having the back surface shown in Fig. 1, obtained as set forth above, was produced (back surface contact type solar cell of Example 1). For the first and second interconnectors 131 and 132, a strip-like conductive member constituted of copper, having a width of 2.5 mm and a thickness of 0.28 mm, was employed.

The voltage-current curve of the back surface contact type solar cell of Example 1 produced as set forth above was measured. The short-circuit current density (mA/cm²), open voltage (V) and fill factor (F.F) values were calculated from the voltage-current curve. The results are shown in Table 1.

### (Example 2)

A back surface contact type solar cell having a back surface shown in Fig. 5 was produced. The size of the silicon substrate used for the production of this back surface contact type solar cell, the size of the back surface contact type solar cell, the width of the n type region, the width of the p type region, the pitch between the n type region and p type region, the width of the finger n electrode, the width of the finger p electrode, and the pitch between the finger n electrode and finger p electrode were the same as those of Example 1.

Following production of a back surface contact type solar cell likewise with Example 1, insulation paste (UV curing type insulation ink made by Jujo Chemical Co., Ltd.) was applied to respective regions of first non-connection region 141 and second non-connection region 142 shown in Fig. 7, followed by drying, and irradiation with UV (Ultra Violet ray) for 10 minutes to be cured. Thus an insulation layer was formed.

Likewise with Example 1, a back surface contact type solar cell having a configuration in which first and second interconnectors 131 and 132 are connected, as shown in Fig. 7, to finger p electrode 121 and finger n electrode 122, respectively, of the back surface contact type solar cell having the back surface of Fig. 5 was produced (back surface contact type solar cell of Example 2).

The voltage-current curve of the back surface contact type solar cell of Example 2 produced as set forth above was measured, likewise with Example 1. From this voltage-current curve, the short-circuit current density (mA/cm²), open voltage (V) and fill factor (F.F) values were calculated from the voltage-current curve. The results are shown in Table 1.

### (Comparative Example)

A back surface contact type solar cell having a back surface shown in Fig. 10 was produced (back surface contact type solar cell of Comparative Example). The size of the silicon substrate used for the production of this back surface contact type solar cell, the size of the back surface contact type solar cell, the width of the n type region, the width of the p type region, the pitch between the n type region and p type region, the width of the finger n electrode, and the pitch between the finger n electrode and finger p electrode were the same as those of Example 1, with the exception that the width of the finger p electrode was modified to 800 µm.

The voltage-current curve of the produced back surface contact type solar cell of the Comparative Example was measured, likewise with Example 1. From this voltage-current curve, the short-circuit current density (mA/cm²), open voltage (V) and fill factor values were calculated from the voltage-current curve. The results are shown in Table 1.

Although measurement of the aforementioned voltage-current curve was performed using a dedicated jig for the back surface contact type solar cell of the Comparative Example, the measurement results can be taken equal to those measured with an interconnector connected.

**Table 1**

| | Short-circuit current density (mA/cm²) | Open voltage (V) | Fill factor value |
|---|---|---|---|
| Example 1 | 37.33 | 0.635 | 0.766 |
| Example 2 | 37.08 | 0.631 | 0.776 |
| Comparative Example | 36.51 | 0.638 | 0.755 |

As shown in Table 1, the back surface contact type solar cells of Example 1 and Example 2 exhibited a higher short-circuit current density (mA/cm²) and higher fill factor value, as compared to those of the back surface contact type solar cell of the Comparative Example. This is possibly attributed to the advantage of not having to form a bus bar p electrode 123 and a bus bar n electrode 124, as in a back surface contact type solar cell of Comparative Example having a back surface shown in Fig. 10, which in turn allows a larger pn junction area at the back surface, and reduction in the series resistance due to a shorter length of finger p electrode 121 and finger n electrode 122.

Therefore, the back surface contact type solar cell of the present invention can have the characteristics improved, as compared to a conventional back surface contact type solar cell.

In the back surface contact type solar cell of Example 1 and Example 2, the shape of finger p electrode 121 and finger n electrode 122 exposed at the back surface is symmetric when the back surface contact type solar cell is rotated 180° with the axis orthogonal to the back surface as an axis of rotation.

Further, by aligning each one back surface contact type solar cell while being rotated at 180°, as shown in Figs. 4 and 8, these back surface contact type solar cells can be connected by means of a strip-like interconnector. Therefore, a solar cell string and solar cell module can be fabricated more readily.

It should be understood that the embodiments and examples disclosed herein are illustrative and non-restrictive in every respect. The scope of the present invention is defined by the appended claims, rather than the description set forth above, and all changes that fall within limits and bounds of the claims, or equivalence thereof are intended to be embraced by the claims.

### INDUSTRIAL FIELD OF APPLICATION

According to the present invention, there can be provided a back surface contact type solar cell, a back surface contact type solar cell with a wiring board, a solar cell string, and solar cell module that can have the characteristics improved, and that can be connected relatively readily.

## Claims

1. A back surface contact type solar cell, comprising:
a first conductivity type region (111) and a second conductivity type region (112) formed alternately at one surface of a semiconductor substrate (101),
an electrode for first conductivity type (121) arranged on said first conductivity type region (111),
an electrode for second conductivity type (122) arranged on said second conductivity type region (112),
a first non-connection region (141) between the electrodes for second conductivity type (122) adjacent in an aligning direction of said first conductivity type region (111) and said second conductivity type region (112), said first non-connection region (141) impeding electrical connection with said electrode for first conductivity type (121), and
a second non-connection region (142) between the electrodes for first conductivity type (121) adjacent in the aligning direction of said first conductivity type region (111) and said second conductivity type region (112), said second non-connection region (142) impeding electrical connection with said electrode for second conductivity type (122).

2. The back surface contact type solar cell according to claim 1, wherein said first non-connection region (141) includes at least one of a region where said electrode for first conductivity type (121) is not arranged on said first conductivity type region (111), and a region where an insulation layer is formed on a surface of said electrode for first conductivity type (121).

3. The back surface contact type solar cell according to claim 1, wherein said second non-connection region (142) includes at least one of a region where said electrode for second conductivity type (122) is not arranged on said second conductivity type region (112) and a region where an insulation layer is formed on a surface of said electrode for second conductivity type (122).

4. The back surface contact type solar cell according to claim 1, wherein said first non-connection region (141) and said electrode for second conductivity type (122) are adjacent in the aligning direction of said first conductivity type region (111) and said second conductivity type region (112).

5. The back surface contact type solar cell according to claim 1, wherein said second non-connection region (142) and said electrode for first conductivity type (121) are adjacent in the aligning direction of said first conductivity type region (111) and said second conductivity type region (112).

6. The back surface contact type solar cell according to claim 1, wherein, when said semiconductor substrate (101) is rotated 180° with an axis orthogonal to the surface of said semiconductor substrate (101) as an axis of rotation, a shape of said electrode for first conductivity type (121) and a shape of said electrode for second conductivity type (122) are identical or symmetric before and after the rotation.

7. The back surface contact type solar cell according to claim 1, wherein, when said semiconductor substrate (101) is of a first conductivity type, an area of said second conductivity type region (112) is larger than the area of said first conductivity type region (111), and when said semiconductor substrate (101) is of a second conductivity type, an area of said first conductivity type region (111) is larger than the area of said second conductivity type region (112).

8. The back surface contact type solar cell according to claim 1, wherein said electrode for first conductivity type (121) takes a shape of a strip extending in a direction orthogonal to the aligning direction of said first conductivity type region (111) and said second conductivity type region (112).

9. The back surface contact type solar cell according to claim 1, wherein said electrode for second conductivity type (122) takes a shape of a strip extending in a direction orthogonal to the aligning direction of said first conductivity type region (111) and said second conductivity type region (112).

10. The back surface contact type solar cell according to claim 1, comprising at least one of a first interconnector (131) electrically connecting electrodes for first conductivity type (121) with each other, and a second interconnector (132) electrically connecting electrodes for second conductivity type (122) with each other.

11. The back surface contact type solar cell according to claim 10, wherein said electrode for first conductivity type (121) takes a shape of a strip extending in a direction orthogonal to the aligning direction of said first conductivity type region (111) and said second conductivity type region (112), and said first interconnector (131) is connected in a direction orthogonal to a longitudinal direction of said electrode for first conductivity type (121).

12. The back surface contact type solar cell according to claim 10, wherein said electrode for second conductivity type (122) takes a shape of a strip extending in a direction orthogonal to the aligning direction of said first conductivity type region (111) and said second conductivity type region (112), and said second interconnector (132) is connected in a direction orthogonal to a longitudinal direction of said electrode for second conductivity type (122).

13. The back surface contact type solar cell according to claim 10, wherein said semiconductor substrate (101) is of an n type, and said first conductivity type and said second conductivity type are an n type and a p type, respectively.

14. A solar cell string comprising a back surface contact type solar cell as recited in claim 1.

15. A solar cell module constituted of the solar cell string as recited in claim 14, sealed with resin.

16. A back surface contact type solar cell with a wiring board, comprising:
a back surface contact type solar cell as recited in claim 1, and
a wiring board (150) including an insulative substrate (151) and a conductive wiring member (152) formed on a surface of said insulative substrate (151),
said back surface contact type solar cell arranged on said wiring member (152) of said wiring board (150), and including a plurality of said electrodes for first conductivity type (121) and a plurality of said electrodes for second conductivity type (122),
the electrodes for first conductivity type (121) being electrically connected with each other by a wiring member (152) of said wiring board (150), and the electrodes for second conductivity type (122) electrically connected with each other by a wiring member (152) differing from said wiring member (152) electrically connecting the electrodes for first conductivity type (121) with each other, in said back surface contact type solar cell.

17. A solar cell string comprising:
a plurality of back surface contact type solar cells as recited in claim 1, and
a wiring board (150) including an insulative substrate (151), and a conductive wiring member (152) formed on a surface of said insulative substrate (151),
each of the plurality of back surface contact type solar cells being arranged on said wiring member (152) of said wiring board (150),
each back surface contact type solar cell including a plurality of said electrodes for first conductivity type (121) and a plurality of said electrodes for second conductivity type (122), wherein
in each of the plurality of back surface contact type solar cells, said electrodes for first conductivity type (121) are electrically connected with each other by a wiring member (152) of said wiring board (150), and said electrodes for second conductivity type (122) are electrically connected with each other by a wiring member (152) differing from said wiring member (152) electrically connecting said electrodes for first conductivity type (121),
said wiring member (152) electrically connecting said electrodes for first conductivity type (121) with each other is also a wiring member (152) electrically connecting the electrodes for second conductivity type (122) of another adjacent back surface contact type solar cell, and
said wiring member (152) electrically connecting said electrodes for second conductivity type (122) with each other is also a wiring member (152) electrically connecting the electrodes for first conductivity type (121) of another adjacent back surface contact type solar cell.

18. A solar cell module constituted of the solar cell string as recited in claim 17, sealed with resin.
